# EUROPÄISCHE PATENTSCHRIFT

(11) **EP 2 342 954 B1**
(45) Veröffentlichungstag und Bekanntmachung des Hinweises auf die Patenterteilung: **13.11.2013**
(21) Anmeldenummer: 09778247.8
(22) Anmeldetag: 01.09.2009
(51) Int. Cl.: H01L 23/498, H03H 7/01, H05K 1/16, H03H 1/00

(54) **ELEKTRISCHE SCHALTUNGSANORDNUNG MIT ÜBERLAPPENDEN KAPAZITÄTEN**
ELECTRICAL CIRCUIT CONFIGURATION HAVING OVERLAPPING CAPACITANCES
CIRCUITERIE ÉLECTRIQUE À CONDENSATEURS CHEVAUCHANTS

(30) Priorität: 16.10.2008 DE 102008051920
(43) Veröffentlichungstag der Anmeldung: 13.07.2011
(73) Patentinhaber: Rohde & Schwarz GmbH & Co. KG, 81671 München (DE)
(72) Erfinder: FLUHRER, Christoph, 82061 Neuried (DE)
(74) Vertreter: Körfer, Thomas
(86) Internationale Anmeldenummer: PCT/EP2009/006321
(87) Internationale Veröffentlichungsnummer: WO 2010/043285

(56) Entgegenhaltungen:
- WO-A1-2008/097911
- US-A1- 2002 098 611
- US-A1- 2004 118 602
- US-A1- 2005 052 268
- US-A1- 2006 291 177
- US-A1- 2007 152 883
- US-A1- 2008 212 262
- US-A1- 2008 238 587
- KAI ZOSCHKE ET AL: "Stackable Thin Film Multi Layer Substrates with Integrated Passive Components", ELECTRONIC COMPONENTS AND TECHNOLOGY CONFERENCE 2006, 56TH SAN DIEGO, CA MAY 30 - JUNE 2, 2006, PISCATAWAY, NJ, USA,IEEE, 30 May 2006 (2006-05-30), pages 806-813, XP010923479, ISBN: 978-1-4244-0152-9
- KRAL A ET AL: "RF-CMOS oscillators with switched tuning", CUSTOM INTEGRATED CIRCUITS CONFERENCE, 1998. PROCEEDINGS OF THE IEEE 1 998 SANTA CLARA, CA, USA 11-14 MAY 1998, NEW YORK, NY, USA,IEEE, US, 11 May 1998 (1998-05-11), pages 555-558, XP010293959, DOI: 10.1109/CICC.1998.695039 ISBN: 978-0-7803-4292-7
- RHONDA F DRAYTON ET AL: "Monolithic Packaging Concepts for High Isolation in Circuits and Antennas", IEEE TRANSACTIONS ON MICROWAVE THEORY AND TECHNIQUES, IEEE SERVICE CENTER, PISCATAWAY, NJ, US, vol. 46, no. 7, 1 July 1998 (1998-07-01), XP011037207, ISSN: 0018-9480
- JERRY FIEDZIUSZKO S ET AL: "Dielectric Materials, Devices, and Circuits", IEEE TRANSACTIONS ON MICROWAVE THEORY AND TECHNIQUES, IEEE SERVICE CENTER, PISCATAWAY, NJ, US, vol. 50, no. 3, 1 March 2002 (2002-03-01), XP011038641, ISSN: 0018-9480

## Beschreibung

Die Erfindung betrifft eine elektrische Schaltungsanordnung mit konzentrierten Elementen, insbesondere überlappend angeordneten Kapazitäten. Die Erfindung betrifft weiterhin ein Filter, welches die elektrische Schaltungsanordnung beinhaltet.

Herkömmlich werden Kapazitäten in Schaltungen als konzentrierte diskrete Bauelemente realisiert. So sind eine hohe Genauigkeit der Bauteiltoleranzen und ein vertretbarer Aufwand der Herstellung zu erreichen. Die resultierenden Kapazitäten nehmen jedoch in Schaltungen einen großen Raum ein und erfüllen die Bedingung der Symmetrie nicht immer optimal. Ein Ansatz zur Beseitigung dieser Schwierigkeiten ist die Nutzung integrierter Kapazitäten.

Filterstrukturen mit diskreten Bauelementen werden herkömmlich auf Leiterplatten hergestellt. Dies erzeugt einen großen Platzbedarf. Weiterhin sind die Filter aufgrund des Aufbaus der Leiterplatte und der einzelnen Bauelemente nicht unbedingt ausreichend symmetrisch. Durch den Einsatz von keramischen Substraten und darauf integrierten Induktivitäten kann der Platzbedarf reduziert werden.

So zeigt die US 2005/0200431 A1 ein Filter auf einem keramischen Mehrlagensubstrat, welches Induktivitäten direkt als Leiterbahnen auf den Lagen des Substrats realisiert. So ist ein reduzierter Flächenbedarf gegenüber Leiterplatten möglich. Auf Grund der Nutzung von keramischen Substraten ist jedoch ein hoher Herstellungsaufwand die Folge.

Die US Patentanmeldung US 2008/0238587 A1 zeigt eine elektrische Schaltungsanordnung mit einem Mehrlagensubstrat und zumindest vier leitfähigen Flächen. Zumindest zwei der vier leitfähigen Flächen befinden sich auf der Oberfläche zweier unterschiedlicher gegenüberliegender Seiten des Substrats und bilden dabei eine Kapazität. Zumindest zwei weitere leitfähige Flächen befinden sich auf jeweils unterschiedlichen Seiten des Substrats, jedoch nicht auf der Oberfläche des Substrats. Sie bilden mit den ersten leitfähigen Flächen auf jeweils einer Seite des Substrats Kapazitäten. Die beiden Oberflächen des Substrats sind dabei mittels leitfähiger Durchkontraktierungen verbunden. Weiterhin ist der Anmeldung ein Filter zu entnehmen, welches die beschriebene elektrische Schaltungsanordnung und eine Induktivität beinhaltet.

Das Dokument "Stackable Thin Film Multi Layer Substrates with Integrated Passive Components, Electronic components and technology conference 2006, 56th San Diego, Ca May 30 - June 2, 2006" zeigt einen Filter mit Kapazitäten und Induktivitäten, welche in verschiedenen Lagen eines Mehrlagen-Substrats angeordnet sind. Jede Lage des Mehrlagen-Substrats besteht dabei aus einem Dielektrikum, auf dessen Oberseite bzw. Unterseite leitfähige Flächen angeordnet sein können. Diese leitfähigen Flächen sind dabei jeweils zwischen zwei Lagen des Substrats angeordnet. Jeweils zwei der leitfähigen Flächen bilden eine Kapazität des Filters.

Das Dokument US 2002/0098611 A1 zeigt einen in eine Filterschaltung integrierten Hohlraum.

Der Erfindung liegt die Aufgabe zu Grunde, ein Filter mit geringem Platzbedarf zu schaffen.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Ein Filter beinhaltet eine elektrische Schaltungsanordnung, welche ein Substrat und zumindest vier leitfähige Flächen beinhaltet. Dabei sind zumindest zwei der zumindest vier leitfähigen Flächen auf der Oberfläche zweier unterschiedlicher Seiten des Substrats angeordnet und bilden eine Kapazität. Zumindest zwei weitere leitfähige Flächen sind auf unterschiedlichen Seiten des Substrats angeordnet und bilden mit zumindest der auf der Oberfläche der jeweiligen Seite des Substrats angeordneten leitfähigen Fläche jeweils eine Kapazität. Das Filter beinhaltet zumindest eine erste Induktivität, welche konzentriert ist. Diese ist als leitfähiger Streifen auf dem Substrat realisiert. Die beiden Oberflächen des Substrats sind mittels zumindest einer leitfähigen Durchkontaktierung verbunden. Die zumindest eine Induktivität ist aus Teilinduktivitäten auf der Oberfläche der beiden Seiten des Substrats gebildet. Zwischen den leitfähigen Flächen auf der Oberfläche des Substrats und den zumindest zwei weiteren leitfähigen Flächen ist nur ein Hohlraum angeordnet. So ist ein einfacher Filteraufbau mit sehr geringem Platzbedarf gewährleistet. Eine einfache Fertigung ist so möglich. Die zwei auf der Oberfläche des Substrats angeordneten leitfähigen Flächen überlappen vorteilhafterweise teilweise. So können die erzeugten Kapazitäten genau eingestellt werden.

Bevorzugt bestimmen die Flächen, um welche die leitfähigen Flächen auf der Oberfläche der beiden Seiten des Substrats überlappen, die Kapazitäten. Auch dient dies der genauen Einstellbarkeit der Kapazitäten.

Die zumindest zwei weiteren leitfähigen Flächen werden bevorzugt durch ein metallisches Gehäuse gebildet. So fällt nur ein geringer Herstellungsaufwand an. Weiterhin ist eine gute Abschirmung der Schaltungsanordnung gewährleistet.

Bevorzugt ist die elektrische Schaltungsanordnung zumindest gegenüber einer Achse symmetrisch aufgebaut. Dies dient der Verbesserung der Hochfrequenzeigenschaften.

Der leitfähige Streifen, welcher die zumindest eine Induktivität bildet, weist bevorzugt eine Krümmung auf und/oder ist bevorzugt schleifenförmig und/oder spiralförmig angeordnet. So sind ein platzsparender Einsatz der Induktivität und damit ein geringer Platzbedarf des Filters möglich.

Das Filter ist bevorzugt ein Tiefpass-Filter. So können die ansonsten großvolumigen Filter mit geringerem Platzverbrauch aufgebaut werden.

Vorteilhafterweise ist die zumindest eine Induktivität derart angeordnet, dass sie parallel zu der von den leitfähigen Flächen auf der Oberfläche der beiden Seiten des Substrats gebildeten Kapazität geschaltet ist. So können vielfältige Filterstrukturen realisiert werden.

Das Filter enthält vorteilhafterweise mehrere zuvor beschriebene elektrische Schaltungsanordnungen, wobei bevorzugt zumindest eine leitfähige Fläche Bestandteil mehrerer der elektrischen Schaltungsanordnungen ist. So kann der Platzbedarf weiter reduziert werden. Die Filtereigenschaften verbessern sich ebenfalls bei größerer Ordnung des Filters.

Bevorzugt verfügt das Filter über vier zuvor beschriebene elektrische Schaltungsanordnungen. Es verfügt bevorzugt über eine erste elektrisch leitfähige Fläche auf einer ersten Seite des Substrats und über eine zweite elektrisch leitfähige Fläche auf einer zweiten Seite des Substrats. Das Filter verfügt bevorzugt weiterhin über eine dritte und eine vierte elektrisch leitfähige Fläche auf der Oberfläche der ersten Seite des Substrats und über eine fünfte, eine sechste und eine siebte elektrisch leitfähige Fläche auf der Oberfläche der zweiten Seite des Substrats. Die erste, zweite, dritte und fünfte elektrisch leitfähige Fläche bilden bevorzugt ein erstes zuvor beschriebenes elektrisches Schaltungselement. Die erste, zweite, dritte und sechste elektrisch leitfähige Fläche bilden bevorzugt ein zweites zuvor beschriebenes elektrisches Schaltungselement. Die erste, zweite, vierte und sechste elektrisch leitfähige Fläche bilden bevorzugt ein drittes zuvor beschriebenes elektrisches Schaltungselement. Die erste, zweite, vierte und siebte elektrisch leitfähige Fläche bilden bevorzugt ein viertes zuvor beschriebenes elektrisches Schaltungselement. So kann ein Filter sehr hoher Ordnung mit geringem Platzbedarf erzeugt werden.

Vorteilhafterweise bilden die zweite und die fünfte leitfähige Fläche eine erste Kapazität und die erste und die dritte leitfähige Fläche eine zweite Kapazität. Die zweite und die sechste leitfähige Fläche bilden bevorzugt eine dritte Kapazität. Die erste und die vierte leitfähige Fläche bilden vorteilhafterweise eine vierte Kapazität. Bevorzugt bilden die zweite und die siebte leitfähige Fläche eine fünfte Kapazität. Die erste Kapazität und die fünfte Kapazität weisen bevorzugt eine ähnliche Größe auf. Vorteilhafterweise ist die zweite Kapazität größer als die dritte Kapazität und die dritte Kapazität größer als die vierte Kapazität und die vierte Kapazität größer als die fünfte Kapazität. So können sehr günstige Filtereigenschaften erzielt werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: eine erste beispielhafte Ausführung einer elektrischen Schaltungsanordnung;
- Fig. 2: eine zweite beispielhafte Ausführung einer elektrischen Schaltungsanordnung;
- Fig. 3: eine dritte beispielhafte Ausführung einer elektrischen Schaltungsanordnung;
- Fig. 4: eine vierte beispielhafte Ausführung einer elektrischen Schaltungsanordnung;
- Fig. 5: eine erste beispielhafte Ausführung des erfindungsgemäßen Filters;
- Fig. 6: eine zweite beispielhafte Ausführung des erfindungsgemäßen Filters, und
- Fig. 7: ein Ersatzschaltbild des erfindungsgemäßen Filters.

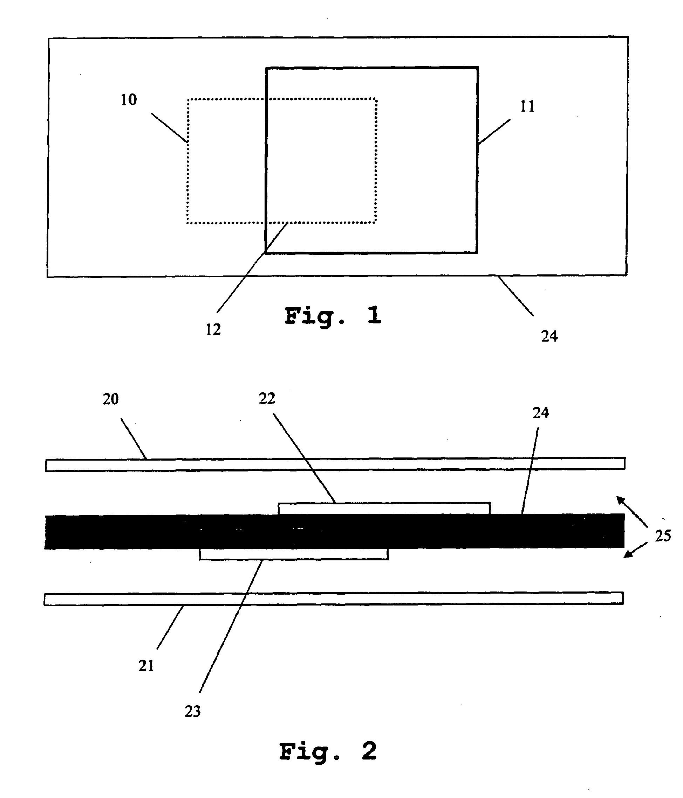

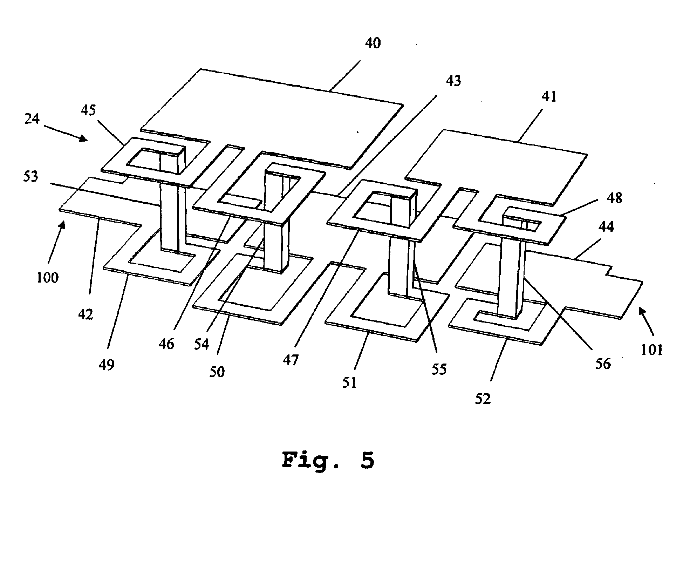

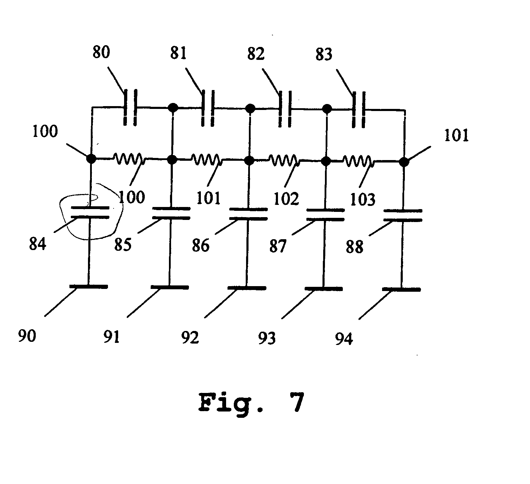

Zunächst wird anhand der Fig. 1 - 4 der Aufbau und die Funktionsweise von elektrischen Schaltungsanordnungen erläutert. Mittels Fig. 5 - 6 wird der Aufbau und die Funktionsweise verschiedener Formen des erfindungsgemäßen Filters veranschaulicht und in Fig. 7 ein Ersatzschaltbild angegeben. Identische Elemente wurden in ähnlichen Abbildungen zum Teil nicht wiederholt dargestellt und beschrieben.

In Fig. 1 wird eine erste beispielhafte Ausführung einer elektrischen Schaltungsanordnung dargestellt. Zwei elektrisch leitfähige Flächen 10, 11 sind auf den beiden Oberflächen eines Substrats 24 angeordnet. Die Fläche 10 ist dabei auf der Unterseite des Substrats 24 angeordnet. Die Fläche 11 ist dabei auf der Oberseite des Substrats 24 angeordnet. Die beiden leitfähigen Flächen 10, 11 überlappen sich teilweise. Die Überlappungsfläche 12 der leitfähigen Flächen 10, 11 bildet dabei eine Kapazität. Die Kapazität ist in etwa proportional zu der Größe der Überlappungsfläche 12. Die leitfähigen Flächen 10, 11 bilden weiterhin Kapazitäten zu einem umgebenden metallischen Gehäuse. Dieses ist in dieser Abbildung jedoch nicht dargestellt.

Fig. 2 zeigt eine zweite beispielhafte Ausführung einer elektrischen Schaltungsanordnung. Die Darstellung entspricht der Seitenansicht des in Fig. 1 Gezeigten. Die beiden elektrisch leitfähigen Flächen 22, 23 sind auf den beiden Oberflächen des Substrats 24 angeordnet. Die elektrisch leitfähige Fläche 22 ist dabei auf der Oberseite des Substrats 24 angeordnet. Die elektrisch leitfähige Fläche 23 ist dabei auf der Unterseite des Substrats 24 angeordnet.

Über Fig. 1 hinaus sind hier die weiteren elektrisch leitfähigen Flächen 20, 21 dargestellt. Diese entsprechen dem metallischen Gehäuse, welches im Abschnitt zu Fig. 1 angedeutet wird. Die elektrisch leitfähigen Flächen 20, 21 sind mit einem Abstand zu dem Substrat 24 angeordnet. Dieser Abstand wird durch nur einen Hohlraum 25 gefüllt.

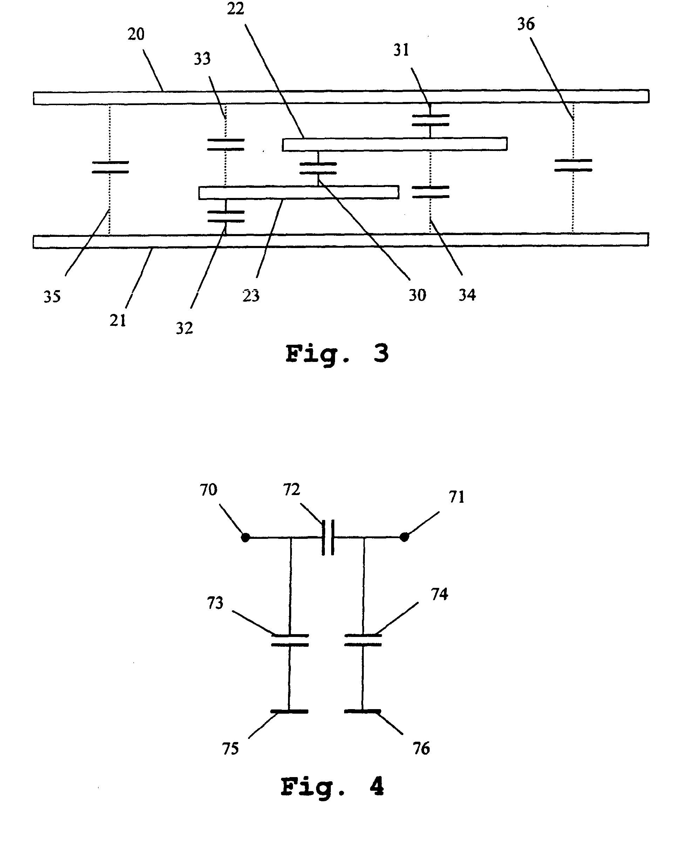

In Fig. 3 wird eine dritte beispielhafte Ausführung einer elektrischen Schaltungsanordnung dargestellt. Diese Darstellung entspricht der Darstellung aus Fig. 2. Zusätzlich sind die zwischen den einzelnen leitfähigen Flächen 20, 21, 22, 23 bestehenden Kapazitäten 30 - 36 eingezeichnet. Diese sind jedoch rein zur Veranschaulichung eingefügt. Es sind keine zusätzlichen kapazitiven Bauelemente zwischen den leitfähigen Flächen 20, 21, 22, 23 angeordnet. Darüber hinaus wurde zur Erhöhung der Anschaulichkeit auf die Darstellung des Substrats 24 verzichtet.

Eine Kapazität 30 wird von den elektrisch leitfähigen Flächen 22, 23 gebildet. Aufgrund des zwischen den elektrisch leitfähigen Flächen 22, 23 angeordneten Substrats 24 aus Fig. 2 handelt es sich um eine verhältnismäßig große Kapazität 30. Diese Kapazität 30 ist abhängig von der Überlappungsfläche der elektrisch leitfähigen Flächen 22, 23. Die elektrisch leitfähigen Flächen 20, 22 bilden ebenfalls eine Kapazität 31. Aufgrund des Hohlraums zwischen diesen elektrisch leitfähigen Flächen 20, 22 ist diese Kapazität 31 verhältnismäßig geringer. Ebenso bilden die elektrisch leitfähigen Flächen 21, 23 eine solche verhältnismäßig geringe Kapazität 32. Darüber hinaus bilden die elektrisch leitfähigen Flächen 20, 21, 22, 23 parasitäre Kapazitäten 33, 34, 35, 36. Diese parasitären Kapazitäten sind jedoch im Verhältnis zu den Kapazitäten 30, 31, 32 sehr klein und werden im Folgenden vernachlässigt.

Fig. 4 zeigt eine vierte beispielhafte Ausführung einer elektrischen Schaltungsanordnung. In dieser Darstellung wird ein Ersatzschaltbild der in Fig. 2 und 3 dargestellten elektrischen Schaltungsanordnung gezeigt. Eine Kapazität 72 ist mit den beiden Anschlüssen 70, 71 verbunden. Der Anschluss 70 ist weiterhin über eine zweite Kapazität 73 mit einem Masseanschluss 75 verbunden. Der Anschluss 71 ist über eine dritte Kapazität 74 mit einem Masseanschluss 76 verbunden. Die erste Kapazität 72 entspricht dabei der Kapazität 30 aus Fig. 3. die zweite Kapazität 73 entspricht dabei der Kapazität 32 aus Fig. 3. Die dritte Kapazität 74 entspricht dabei der Kapazität 31 aus Fig. 3. Der Anschluss 70 entspricht dabei der elektrisch leitfähigen Fläche 23 aus Fig. 2 und Fig. 3. Der Anschluss 71 entspricht dabei der elektrisch leitfähigen Fläche 22 aus Fig. 2 und Fig. 3.

In Fig. 5 wird eine erste beispielhafte Ausführung des erfindungsgemäßen Filters dargestellt. Das beispielhafte Filter enthält eine Mehrzahl an elektrisch leitfähigen Flächen 40 - 44. Die elektrisch leitfähigen Flächen 40, 41 sind auf einer Oberfläche eines hier nicht eingezeichneten Substrats 24 angeordnet. Die elektrisch leitfähigen Flächen 42, 43, 44 sind auf der anderen Oberfläche des Substrats 24 angeordnet. Die elektrische leitfähigen Flächen mit 40, 42 bilden eine erste Kapazität. Die elektrisch leitfähigen Flächen 40, 43 bilden eine zweite Kapazität. Die elektrisch leitfähigen Flächen 41, 43 bilden eine dritte Kapazität. Weiterhin bilden die elektrisch leitfähigen Flächen 41, 44 eine vierte

Kapazität. Jede der elektrisch leitfähigen Flächen 40 - 44 bildet mit jeweils einer weiteren, hier nicht dargestellten elektrisch leitfähigen Fläche eine weitere Kapazität. Die hier nicht dargestellten elektrisch leitfähigen Flächen entsprechen den elektrisch leitfähigen Flächen 20, 21 aus Fig. 2 und Fig. 3.

Darüber hinaus beinhaltet das beispielhafte Filter eine Mehrzahl an Induktivitäten welche aus Teil-Induktivitäten 45 - 52 zusammengesetzt sind. Die Teil-Induktivitäten 45 - 52 sind dabei auf den beiden unterschiedlichen Oberflächen des Substrats angeordnet und mit den elektrisch leitfähigen Flächen 40 - 45 verbunden.

Die elektrisch leitfähige Fläche 40 ist mit der Teil-Induktivität 45 verbunden. Diese ist mittels einer elektrischen Durchkontaktierung 53 mit der Teil-Induktivität 49 verbunden. Diese ist mit der elektrisch leitfähigen Fläche 42 verbunden. Die beiden Teil-Induktivitäten 45, 49 bilden dabei eine Induktivität. Die elektrisch leitfähige Fläche 40 ist weiterhin mit der Teil-Induktivität 46 verbunden. Diese ist mittels einer elektrischen Durchkontaktierung 54 mit der Teil-Induktivität 50 verbunden. Diese ist mit der elektrisch leitfähigen Fläche 43 verbunden. Die beiden Teil-Induktivitäten 46, 50 bilden dabei eine Induktivität. Die elektrisch leitfähige Fläche 41 ist mit der Teil-Induktivität 47 verbunden. Diese ist mittels einer elektrischen Durchkontaktierung 55 mit der Teil-Induktivität 51 verbunden. Diese ist mit der elektrisch leitfähigen Fläche 43 verbunden. Die beiden Teil-Induktivitäten 47, 51 bilden dabei eine Induktivität. Die elektrisch leitfähige Fläche 41 ist weiterhin mit der Teil-Induktivität 48 verbunden. Diese ist mittels einer elektrischen Durchkontaktierung 56 mit der Teil-Induktivität 52 verbunden. Diese ist mit der elektrisch leitfähigen Fläche 44 verbunden. Die beiden Teil-Induktivitäten 48, 52 bilden dabei eine Induktivität.

Das Filter wird über Anschlüsse 100, 101, welche an den elektrisch leitfähigen Flächen 42 und 44 angebracht werden, kontaktiert.

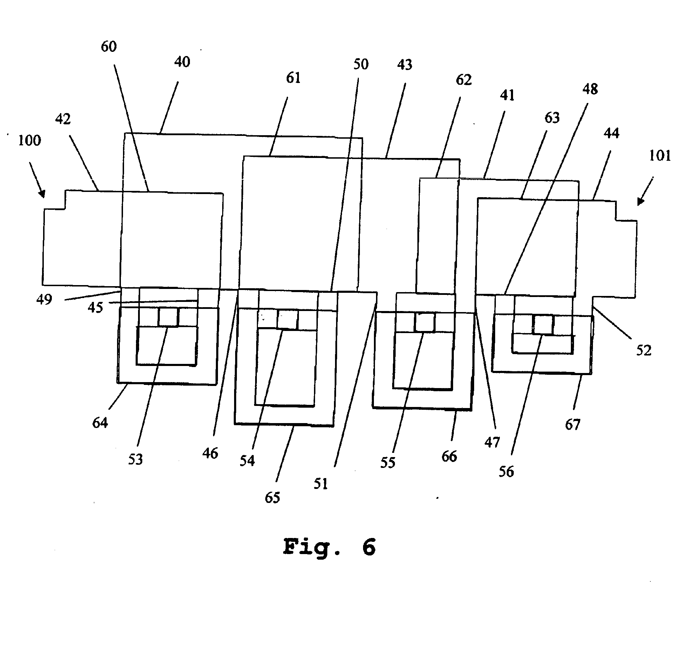

Fig. 6 zeigt eine zweite beispielhafte Ausführung des erfindungsgemäßen Filters. Zur besseren Veranschaulichung wird die Darstellung aus Fig. 5 hier nochmals von oben gezeigt. Aus dieser Darstellung werden insbesondere die Überlappungsflächen 60, 61, 62, 63 deutlich. Die elektrisch leitfähigen Flächen 40, 42 bilden die Überlappungsfläche 60. Die elektrisch leitfähigen Flächen 40, 43 bilden die Überlappungsfläche 61. Die elektrisch leitfähigen Flächen 41, 43 bilden die Überlappungsfläche 62. Die elektrisch leitfähigen Flächen 43, 44 bilden die Überlappungsfläche 63. Aus dieser Darstellung werden ebenfalls die aus den Teil-Induktivitäten 45 - 52 gebildeten Induktivitäten 64 - 67 deutlich. So bilden die Teil-Induktivitäten 45, 49 die Induktivität 64. Weiterhin bilden die Teil-Induktivitäten 46, 50 die Induktivität 65. Die Teil-Induktivitäten 47, 51 bilden die Induktivität 66. Die Teil-Induktivitäten 48, 52 bilden die Induktivität 67.

In Fig. 7 wird eine dritte beispielhafte Ausführung des erfindungsgemäßen Filters dargestellt. Hier wird ein Ersatzschaltbild des Filters von Fig. 5 und Fig. 6 gezeigt. Die Überlappungsflächen 60 - 63 aus Fig. 6 und Fig. 7 entsprechen hier den Kapazitäten 80 - 83. Die konzentrierten Induktivitäten 64 - 67 aus Fig. 6 und Fig. 7 entsprechen den diskreten Induktivitäten 100 - 103. Die von den leitfähigen Flächen 40 - 44 mit den nicht dargestellten umgebenden leitfähigen Flächen gebildeten Kapazitäten entsprechen hier den Kapazitäten 84 - 88. Diese entsprechen den Kapazitäten 31, 32 aus Fig. 3. Die Masseanschlüsse 90 - 94 in dieser Darstellung entsprechen dem metallischen Gehäuse, welches im Abschnitt zu Fig. 1 angedeutet wird und den verbundenen leitfähigen Flächen 20, 21 aus Fig. 2 und Fig. 3 entspricht.

Das hier dargestellte Filter ist ein Cauer-Filter. Die Ordnung des Cauer-Filters ist 9. ein Aufbau von Cauer-Filtern mit einer Ordnung beispielsweise im Bereich von 1 bis 11 ist ebenfalls möglich. Auch der Einsatz von Filtern mit noch höherer Ordnung ist denkbar.

Die Erfindung ist nicht auf das dargestellte Ausführungsbeispiel beschränkt. Wie bereits erwähnt, können unterschiedliche Filtertypen realisiert werden. Auch ein Einsatz von Filtern höherer Ordnung ist möglich. Ein Einsatz von mehrlagigen Substraten ist ebenfalls denkbar. Alle vorstehend beschriebenen Merkmale oder in den Figuren gezeigten Merkmale sind im Rahmen der Erfindung beliebig vorteilhaft miteinander kombinierbar.

## Patentansprüche

1. Filter mit zumindest einer elektrischen Schaltungsanordnung,
wobei die elektrische Schaltungsanordnung über ein Substrat (24) und zumindest vier leitfähigen Flächen (10, 11, 20, 21, 22, 23, 40, 41, 42, 43, 44) verfügt,
wobei zumindest zwei leitfähige Flächen (10, 11, 22, 23, 40, 41, 42, 43, 44) der zumindest vier leitfähigen Flächen (10, 11, 20, 21, 22, 23, 40, 41, 42, 43, 44) auf der Oberfläche zweier unterschiedlicher gegenüberliegender Seiten des Substrats (24) angeordnet sind und eine Kapazität (30, 80, 81, 82, 83) bilden,
wobei zumindest zwei weitere leitfähige Flächen (20, 21) jeweils auf einer dieser unterschiedlichen Seiten des Substrats (24) mit einem durch nur einen Hohlraum (25) gefüllten Abstand zum Substrat (24) angeordnet sind und mit zumindest der auf der Oberfläche der jeweiligen Seite des Substrats (24) angeordneten leitfähigen Fläche (10, 11, 22, 23, 40, 41, 42, 43, 44) jeweils eine Kapazität (31, 32, 84, 85, 86, 87, 88) bilden,
wobei
die beiden Oberflächen des Substrats (24) mittels zumindest einer leitfähigen Durchkontaktierung (53, 54, 55, 56) verbunden sind,
wobei das Filter zumindest eine erste Induktivität (64, 65, 66, 67, 100, 101, 102, 103) beinhaltet,
wobei die erste Induktivität (64, 65, 66, 67, 100, 101, 102, 103) konzentriert ist,
die konzentrierte Induktivität (64, 65, 66, 67) als leitfähiger Streifen auf dem Substrat (24) realisiert ist, und
die zumindest eine konzentrierte Induktivität (64, 65, 66, 67) aus Teilinduktivitäten (45, 46, 47, 48, 49, 50, 51, 52) auf der Oberfläche der beiden Seiten des Substrats (24) gebildet ist.

2. Filter nach Anspruch 1,
**dadurch gekennzeichnet,**
**dass** die zwei auf der Oberfläche des Substrats (24) angeordneten leitfähigen Flächen (10, 11, 22, 23, 40, 41, 42, 43, 44) teilweise überlappen.

3. Filter nach Anspruch 2,
**dadurch gekennzeichnet,**
**dass** Flächen (60, 61, 62, 63), um welche die leitfähigen Flächen (10, 11, 22, 23, 40, 41, 42, 43, 44) auf der Oberfläche der beiden Seiten des Substrats (24) überlappen, die jeweiligen Kapazitäten (30, 80, 81, 82, 83) bestimmen.

4. Filter nach einem der Ansprüche 1 bis 3,
**dadurch gekennzeichnet,**
**dass** die zumindest zwei weiteren leitfähigen Flächen (20, 21) durch ein metallisches Gehäuse gebildet werden.

5. Filter nach einem der Ansprüche 1 bis 4,
**dadurch gekennzeichnet,**
**dass** die elektrische Schaltungsanordnung zumindest gegenüber einer Achse symmetrisch aufgebaut ist.

6. Filter nach einem der Ansprüche 1 bis 5,
**dadurch gekennzeichnet,**
**dass** zwischen den leitfähigen Flächen (10, 11, 22, 23, 40, 41, 42, 43, 44) auf der Oberfläche des Substrats (24) und den zumindest zwei weiteren leitfähigen Flächen (20, 21) zumindest ein Hohlraum (25) angeordnet ist.

7. Filter nach Anspruch 6,
**dadurch gekennzeichnet,**
**dass** der leitfähige Streifen, welcher die zumindest eine konzentrierte Induktivität (64, 65, 66, 67) bildet, eine Krümmung aufweist und/oder schleifenförmig und/oder spiralförmig angeordnet ist.

8. Filter nach einem der Ansprüche 1 bis 7,
**dadurch gekennzeichnet,**
**dass** das Filter ein Tiefpass-Filter ist.

9. Filter nach einem der Ansprüche 1 bis 8,
**dadurch gekennzeichnet,**
**dass** die zumindest eine Induktivität (64, 65, 66, 67, 100, 101, 102, 103) derart angeordnet ist, dass sie parallel zu der von den leitfähigen Flächen (10, 11, 22, 23, 40, 41, 42, 43, 44) auf der Oberfläche der beiden Seiten des Substrats (24) gebildeten Kapazität (30, 80, 81, 82, 83) geschaltet ist.

10. Filter nach einem der Ansprüche 1 bis 9,
**dadurch gekennzeichnet,**
**dass** das Filter mehrere elektrische Schaltungsanordnungen nach den Ansprüchen 1 bis 6 enthält, wobei zumindest eine leitfähige Fläche (40, 41, 42, 43, 44) Bestandteil mehrerer der elektrischen Schaltungsanordnungen ist.

11. Filter nach Anspruch 10,
**dadurch gekennzeichnet,**
**dass** das Filter über vier elektrische Schaltungsanordnungen nach den Ansprüchen 1 bis 6 verfügt, dass das Filter über eine erste elektrisch leitfähige Fläche auf einer ersten Seite des Substrats (24) verfügt, dass das Filter über eine zweite elektrisch leitfähige Fläche auf einer zweiten Seite des Substrats (24) verfügt, dass das Filter über eine dritte elektrisch leitfähige Fläche (40) und eine vierte elektrisch leitfähige Fläche (41) auf der Oberfläche der ersten Seite des Substrats (24) verfügt, und
**dass** das Filter über eine fünfte elektrisch leitfähige Fläche (42), eine sechste elektrisch leitfähige Fläche (43) und eine siebte elektrisch leitfähige Fläche (44) auf der Oberfläche der zweiten Seite des Substrats (24) verfügt,

12. Filter nach Anspruch 11,
**dadurch gekennzeichnet,**
**dass** die erste, zweite, dritte und fünfte elektrisch leitfähigen Flächen (40, 42) ein erstes elektrisches Schaltungselement nach den Ansprüchen 1 bis 6 bilden, dass die erste, zweite, dritte und sechste elektrisch leitfähigen Flächen (40, 43) ein zweites elektrisches Schaltungselement nach den Ansprüchen 1 bis 6 bilden, dass die erste, zweite, vierte und sechste elektrisch leitfähigen Flächen (41, 43) ein drittes elektrisches Schaltungselement nach den Ansprüchen 1 bis 6 bilden, und dass die erste, zweite, vierte und siebte elektrisch leitfähigen Flächen (41, 44) ein viertes elektrisches Schaltungselement nach den Ansprüchen 1 bis 6 bilden.

13. Filter nach Anspruch 12,
**dadurch gekennzeichnet,**
**dass** die zweite elektrisch leitfähige Fläche und die fünfte elektrisch leitfähige Fläche (42) eine erste Kapazität (84) bilden,
**dass** die erste elektrisch leitfähige Fläche und die dritte elektrisch leitfähige Fläche (40) eine zweite Kapazität (85) bilden,
**dass** die zweite elektrisch leitfähige Fläche und die sechste elektrisch leitfähige Fläche (43) eine dritte Kapazität (86) bilden,
**dass** die erste elektrisch leitfähige Fläche und die vierte elektrisch leitfähige Fläche (41) eine vierte Kapazität (87) bilden, und
**dass** die zweite elektrisch leitfähige Fläche und die siebte elektrisch leitfähige Fläche (44) eine fünfte Kapazität (88) bilden.

14. Filter nach Anspruch 13,
**dadurch gekennzeichnet,**
**dass** die erste Kapazität (84) und die fünfte Kapazität (88) eine ähnliche Größe aufweisen,
**dass** die zweite Kapazität (85) größer ist als die dritte Kapazität (86),
**dass** die dritte Kapazität (86) größer ist als die vierte Kapazität (87), und
**dass** die vierte Kapazität (87) größer ist als die fünfte Kapazität (88).

## Claims

1. Filter comprising at least one electrical circuit assembly,
wherein the electrical circuit assembly has a substrate (24) and at least four conductive faces (10, 11, 20, 21, 22, 23, 40, 41, 42, 43, 44),
wherein at least two conductive faces (10, 11, 22, 23, 40, 41, 42, 43, 44) of the at least four conductive faces (10, 11, 20, 21, 22, 23, 40, 41, 42, 43, 44) are arranged on the surface of two different, opposing sides of the substrate (24) and form a capacitor (30, 80, 81, 82, 83), wherein at least two further conductive faces (20, 21) are each arranged on one of these different sides of the substrate (24) with spacing, which is filled only by a cavity (25), from the substrate (24) and each form a capacitor (31, 32, 84, 85, 86, 87, 88) together with at least the conductive surface (10, 11, 22, 23, 40, 41, 42, 43, 44) which is arranged on the surface of the respective side of the substrate (24),
wherein the two surfaces of the substrate (24) are connected by means of at least one conductive feed-through (53, 54, 55, 56),
wherein the filter contains at least one first inductor (64, 65, 66, 67, 100, 101, 102, 103), wherein the first inductor (64, 65, 66, 67, 100, 101, 102, 103) is concentrated,
the concentrated inductor (64, 65, 66, 67) is produced on the substrate (24) as a conductive strip, and
the at least one concentrated inductor (64, 65, 66, 67) is formed on the surface of the two sides of the substrate (24) from sub-inductors (45, 46, 47, 48, 49, 50, 51, 52).

2. Filter according to claim 1, **characterised in that** the two conductive faces (10, 11, 22, 23, 40, 41, 42, 43, 44) which are arranged on the surface of the substrate (24) overlap in part.

3. Filter according to claim 2, **characterised in that** faces (60, 61, 62, 63) with which the conductive faces (10, 11, 22, 23, 40, 41, 42, 43, 44) overlap on the surface of the two sides of the substrate (24) determine the respective capacitors (30, 80, 81, 82, 83).

4. Filter according to any of claims 1 to 3, **characterised in that** the at least two further conductive faces (20, 21) are formed by a metal housing.

5. Filter according to any of claims 1 to 4, **characterised in that** the electrical circuit assembly is symmetrically constructed at least relative to one axis.

6. Filter according to any of claims 1 to 5, **characterised in that** at least one cavity (25) is arranged between the conductive faces (10, 11, 22, 23, 40, 41, 42, 43, 44) on the surface of the substrate (24) and the at least two further conductive faces (20, 21).

7. Filter according to claim 6, **characterised in that** the conductive strip, which forms the at least one concentrated inductor (64, 65, 66, 67), is curved and/or loop-shaped and/or spiral-shaped.

8. Filter according to any of claims 1 to 7, **characterised in that** the filter is a low-pass filter.

9. Filter according to any of claims 1 to 8, **characterised in that** the at least one inductor (64, 65, 66, 67, 100, 101, 102, 103) is arranged such that it is connected in parallel with the capacitors (30, 80, 81, 82, 83) which are formed on the surface of the two sides of the substrate (24) by the conductive faces (10, 11, 22, 23, 40, 41, 42, 43, 44).

10. Filter according to any of claims 1 to 9, **characterised in that** the filter contains a plurality of electrical circuit assemblies according to any of claims 1 to 6, at least one conductive face (40, 41, 42, 43, 44) being a component of a plurality of electrical circuit assemblies.

11. Filter according to claim 10, **characterised in that** the filter has four electrical circuit assemblies according to claims 1 to 6, **in that** the filter has a first electrically conductive face on a first side of the substrate (24), **in that** the filter has a second electrically conductive face on a second side of the substrate (24), the filter has a third electrically conductive face (40) and a fourth electrically conductive face (41) on the surface of the first side of the substrate (24), and **in that** the filter has a fifth electrically conductive face (42), a sixth electrically conductive face (43) and a seventh electrically conductive face (44) on the surface of the second side of the substrate (24).

12. Filter according to claim 11, **characterised in that** the first, second, third and fifth electrically conductive faces (40, 42) form a first electrical circuit element according to any of claims 1 to 6, **in that** the first, second, third and sixth electrically conductive faces (40, 43) form a second electrical circuit element according to any of claims 1 to 6, **in that** the first, second, fourth and sixth electrically conductive faces (41, 43) form a third electrical circuit element according to any of claims 1 to 6, and **in that** the first, second, fourth and seventh electrically conductive faces (41, 44) form a fourth electrical circuit element according to any of claims 1 to 6.

13. Filter according to claim 12, **characterised in that** the second electrically conductive face and the fifth electrically conductive face (42) form a first capacitor (84),**in that** the first electrically conductive face and the third electrically conductive face (40) form a second capacitor (85),**in that** the second electrically conductive face and the sixth electrically conductive face (43) form a third capacitor (86),**in that** the first electrically conductive face and the fourth electrically conductive face (41) form a fourth capacitor (87), andin that the second electrically conductive face and the seventh electrically conductive face (44) form a fifth capacitor (88).

14. Filter according to claim 13, **characterised in that** the first capacitor (84) and the fifth capacitor (88) are of a similar size,**in that** the second capacitor (85) is larger than the third capacitor (86),**in that** the third capacitor (86) is larger than the fourth capacitor (87), and **in that** the fourth capacitor (87) is larger than the fifth capacitor (88).

## Revendications

1. Filtre comprenant au moins un agencement de circuit électrique,
dans lequel l'agencement de circuit électrique dispose d'un substrat (24) et d'au moins quatre surfaces conductrices (10, 11, 20, 21, 22, 23, 40, 41, 42, 43, 44),
dans lequel au moins deux surfaces conductrices (10, 11, 22, 23, 40, 41, 42, 43, 44) desdites au moins quatre surfaces conductrices (10, 11, 20, 21, 22, 23, 40, 41, 42, 43, 44) sont agencées sur la surface extérieure de deux côtés différents mutuellement opposés du substrat (24), et forment une capacité (30, 80, 81, 82, 83),
dans lequel au moins deux autres surfaces conductrices (20, 21) sont agencées respectivement sur un de ces côtés différents du substrat (24) avec une distance au substrat (24) occupée uniquement par un espace vide (25), et forment avec au moins la surface conductrice (10, 11, 22, 23, 40, 41, 42, 43, 44) agencée sur la surface extérieure du côté respectif du substrat (24), respectivement une capacité (31, 32, 84, 85, 86, 87, 88),
dans lequel les deux côtés du substrat (24) sont reliés au moyen d'au moins un contact conducteur traversant (53, 54, 55, 56),
le filtre renfermant au moins une première inductance (64, 65, 66, 67, 100, 101, 102, 103),
la première inductance (64, 65, 66, 67, 100, 101, 102, 103) étant concentrée,
l'inductance concentrée (64, 65, 66, 67) étant réalisée en tant que piste conductrice sur le substrat (24), et ladite au moins une inductance concentrée (64, 65, 66, 67) étant formée par des inductances partielles (45, 46, 47, 48, 49, 50, 51, 52) sur la surface extérieure des deux côtés du substrat (24).

2. Filtre selon la revendication 1,
**caractérisé**
**en ce que** les deux surfaces conductrices (10, 11, 22, 23, 40, 41, 42, 43, 44) agencées sur la surface extérieure du substrat (24) se chevauchent partiellement.

3. Filtre selon la revendication 2,
**caractérisé**
**en ce que** des surfaces (60, 61, 62, 63) résultant du chevauchement des surfaces conductrices (10, 11, 22, 23, 40, 41, 42, 43, 44) sur la surface extérieure des deux côtés du substrat (24), déterminent les capacités respectives (30, 80, 81, 82, 83).

4. Filtre selon l'une des revendications 1 à 3,
**caractérisé**
**en ce que** lesdites au moins deux autres surfaces conductrices (20, 21) sont formées par un boitier métallique.

5. Filtre selon l'une des revendications 1 à 4,
**caractérisé**
**en ce que** l'agencement de circuit électrique est d'une configuration symétrique au moins par rapport à un axe.

6. Filtre selon l'une des revendications 1 à 5,
**caractérisé**
**en ce qu'**entre les surfaces conductrices (10, 11, 22, 23, 40, 41, 42, 43, 44) sur la surface extérieure du substrat (24) et lesdites au moins deux autres surfaces conductrices (20, 21), est agencé au moins un espace vide (25).

7. Filtre selon la revendication 6,
**caractérisé**
**en ce que** la piste conductrice, qui forme ladite au moins une inductance concentrée (64, 65, 66, 67) présente une courbure et/ou est agencée en forme de boucle et/ou en forme de spirale.

8. Filtre selon l'une des revendications 1 à 7,
**caractérisé**
**en ce que** le filtre est un filtre passe-bas.

9. Filtre selon l'une des revendications 1 à 8,
**caractérisé**
**en ce que** ladite au moins une inductance (64, 65, 66, 67, 100, 101, 102, 103) est agencée de manière telle, qu'elle soit montée en parallèle avec la capacité (30, 80, 81, 82, 83) formée par les surfaces conductrices (10, 11, 22, 23, 40, 41, 42, 43, 44) sur la surface extérieure des deux côtés du substrat (24).

10. Filtre selon l'une des revendications 1 à 9,
**caractérisé**
**en ce que** le filtre renferme plusieurs agencements de circuit électrique selon les revendications 1 à 6, au moins une surface conductrice (40, 41, 42, 43, 44) faisant partie intégrante de plusieurs des agencements de circuit électrique.

11. Filtre selon la revendication 10,
**caractérisé**
**en ce que** le filtre dispose de quatre agencements de circuit électrique selon les revendications 1 à 6,
**en ce que** le filtre dispose d'une première surface électriquement conductrice sur un premier côté du substrat (24),
**en ce que** le filtre dispose d'une deuxième surface électriquement conductrice sur un deuxième côté du substrat (24),
**en ce que** le filtre dispose d'une troisième surface électriquement conductrice (40) et d'une quatrième surface électriquement conductrice (41) sur la surface extérieure du premier côté du substrat (24), et
**en ce que** le filtre dispose d'une cinquième surface électriquement conductrice (42), d'une sixième surface électriquement conductrice (43) et d'une septième surface électriquement conductrice (44) sur la surface extérieure du deuxième côté du substrat (24).

12. Filtre selon la revendication 11,
**caractérisé**
**en ce que** la première, la deuxième, la troisième et la cinquième surfaces électriquement conductrices (40, 42) forment un premier élément de circuit électrique selon les revendications 1 à 6,
**en ce que** la première, la deuxième, la troisième et la sixième surfaces électriquement conductrices (40, 43) forment un deuxième élément de circuit électrique selon les revendications 1 à 6,
**en ce que** la première, la deuxième, la quatrième et la sixième surfaces électriquement conductrices (41, 43) forment un troisième élément de circuit électrique selon les revendications 1 à 6, et
**en ce que** la première, la deuxième, la quatrième et la septième surfaces électriquement conductrices (41, 44) forment un quatrième élément de circuit électrique selon les revendications 1 à 6.

13. Filtre selon la revendication 12,
**caractérisé**
**en ce que** la deuxième surface électriquement conductrice et la cinquième surface électriquement conductrice (42) forment une première capacité (84),
**en ce que** la première surface électriquement conductrice et la troisième surface électriquement conductrice (40) forment une deuxième capacité (85),
**en ce que** la deuxième surface électriquement conductrice et la sixième surface électriquement conductrice (43) forment une troisième capacité (86),
**en ce que** la première surface électriquement conductrice et la quatrième surface électriquement conductrice (41) forment une quatrième capacité (87), et
**en ce que** la deuxième surface électriquement conductrice et la septième surface électriquement conductrice (44) forment une cinquième capacité (88).

14. Filtre selon la revendication 13,
**caractérisé**
**en ce que** la première capacité (84) et la cinquième capacité (88) présentent une grandeur similaire,
**en ce que** la deuxième capacité (85) est plus grande que la troisième capacité (86),
**en ce que** la troisième capacité (86) est plus grande que la quatrième capacité (87), et
**en ce que** la quatrième capacité (87) est plus grande que la cinquième capacité (88).
